# EUROPEAN PATENT APPLICATION

(11) **EP 4 497 855 A1**
(43) Date of publication of application: **29.01.2025**
(21) Application number: 24190214.7
(22) Date of filing: 23.07.2024
(51) Int. Cl.: C30B 29/36, G01B 15/08, G06T 7/00

(54) **METHOD FOR EVALUATING SIC SUBSTRATE, METHOD FOR MANUFACTURING SIC SUBSTRATE, AND SIC SUBSTRATE EVALUATION DEVICE**

(30) Priority: 24.07.2023 JP 2023120078; 24.10.2023 JP 2023182652
(71) Applicant: Resonac Corporation, Tokyo 105-7325 (JP)
(72) Inventor: SUO, Hiromasa, Tokyo, 105-7325 (JP); ONUKI, Kosuke, Tokyo, 105-7325 (JP)
(74) Representative: Strehl Schübel-Hopf & Partner

(57) **Abstract**

A method for evaluating a SiC substrate according to the present embodiment includes: an image acquisition step of acquiring an X-ray topographic image of an entire first surface of a SiC substrate; and an estimation step of estimating a basal plane dislocation density of the SiC substrate from the X-ray topographic image of the entire first surface of the SiC substrate based on learning results of deep learning.

## Description

### BACKGROUND

### Field

This present disclosure relates to a method for evaluating a SiC substrate, a method for manufacturing a SiC substrate and a SiC substrate evaluation device.

Silicon carbide (SiC) has a dielectric breakdown field that is one order of magnitude larger than that of silicon and a band gap that is three times larger than that of silicon (Si). In addition, SiC has characteristics such as a thermal conductivity that is about three times higher than that of silicon. Therefore, SiC is expected to be applied to power devices, high-frequency devices, and high-temperature operation devices. For this reason, SiC epitaxial wafers have recently been used as substrates for the above-described semiconductor devices.

SiC epitaxial wafer is obtained by stacking a SiC epitaxial layer on the surface of a SiC substrate. Hereafter, a substrate before stacking the SiC epitaxial layer is called a SiC substrate, and a substrate after stacking the SiC epitaxial layer is called a SiC epitaxial wafer. SiC substrates are manufactured by cutting from a SiC ingot. SiC devices such as power devices, high-frequency devices, and high-temperature operation devices are obtained by chipping the SiC epitaxial wafer after forming devices on SiC epitaxial layer of the SiC epitaxial wafer.

Basal plane dislocation (BPD) is known as one of device killer defects in the SiC epitaxial wafer that cause critical defects in SiC devices. For example, when currents are applied in the forward direction of a bipolar device, the recombination energy of the carriers causes partial dislocations of the basal plane dislocations inherited from the SiC substrate by the SiC epitaxial layer to migrate and expand, forming high resistance stacking defects. This high resistance area in the device causes a decrease in device reliability (forward degradation).

Basal plane dislocations in the SiC epitaxial layer are often inherited from basal plane dislocations in the SiC substrate. Therefore, there has been a demand for techniques to evaluate basal plane dislocations in the SiC substrate.

For example, Patent Document 1 discloses a use of a correlation between X-ray topographic image contrast and basal plane dislocations to evaluate in-plane distribution of basal plane dislocations in the SiC substrate.

In addition, for example, Patent Document 2 discloses a technique for classifying individual defects using a neural network.

### [Patent Documents]

[Patent Document 1] Japanese Patent No. 6197722
[Patent Document 2]
   United States Patent Application, Publication No. 2020/365685

### SUMMARY

The method described in Patent Document 1 uses only image contrast as a measurement parameter to determine a dislocation density, which may not be sufficiently accurate in measuring dislocation density. In addition, the SiC substrate with a low dislocation density do not provide a sufficient contrast difference, and the in-plane distribution of basal plane dislocations may not be able to be appropriately evaluated by the method described in Patent Document 1.

The method described in Patent Document 2 requires classification of individual defects and is time consuming to evaluate the overall dislocation density.

The present disclosure has been made in consideration of the above-described problems, and an object of the present disclosure is to provide a method for evaluating a SiC substrate and a method for manufacturing a SiC substrate in which basal plane dislocation density can be simply and quickly measured.

The present inventors have focused on the entire X-ray topographic image instead of focusing on the individual defects. They have found that deep learning using the entire X-ray topographic image enables analysis that also takes into account strain or the like of an entire crystal and can accurately estimate basal plane dislocation density. In addition, by using the entire X-ray topographic image instead of focusing on individual defects, the time required to estimate basal plane dislocation density could be reduced.
(1) A method for evaluating a SiC substrate according to a first aspect includes: an image acquisition step of acquiring an X-ray topographic image of an entire first surface of a SiC substrate; and an estimation step of estimating basal plane dislocation density of the SiC substrate from the X-ray topographic image of the entire first surface of the SiC substrate based on learning results of deep learning.
(2) The method for evaluating a SiC substrate according to the above-described aspect may further include: an image compression step of compressing the X-ray topographic image acquired in the image acquisition step. In the image compression step, the pixel size of the X-ray topographic image is 0.1 mm² or larger. The estimation step is performed using the compressed X-ray topographic image.
(3) The method for evaluating a SiC substrate according to the above-described aspect may further include: a preliminary step of measuring respective X-ray topographic images of a plurality of SiC substrates and respective basal plane dislocation densities of the plurality of SiC substrates. In the preliminary step, a relationship between the basal plane dislocation densities and the X-ray topographic images of the respective SiC substrates is learned by the deep learning.
(4) In the method for evaluating a SiC substrate according to the above-described aspect, the number of SiC substrates measured in the preliminary step may be 100 or more.
(5) In the method for evaluating a SiC substrate according to the above-described aspect, inverted or rotated images of the X-ray topographic images acquired in the preliminary step may be used for the learning.
(6) In the method for evaluating a SiC substrate according to the above-described aspect, the X-ray topographic image may be a diffraction image containing a diffraction vector in the <11-20> direction.
(7) In the method for evaluating a SiC substrate according to the above-described aspect, the X-ray topographic image may be a diffraction image containing a diffraction vector in the <1-100> direction.
(8) In the method for evaluating a SiC substrate according to the above-described aspect, the SiC substrate may have a diameter of 145 mm or more.
(9) In the method for evaluating a SiC substrate according to the above-described aspect, the SiC substrate may have a diameter of 195 mm or more.
(10) In the method for evaluating a SiC substrate according to the above-described aspect, the diameters of the SiC substrates to be measured in the preliminary step may be different from that of the SiC substrate for which the X-ray topographic image is acquired in the image acquisition step.
(11) In the method for evaluating a SiC substrate according to the above-described aspect, the basal plane dislocation density of the SiC substrate may be 1.0×10⁴/cm² or less.
(12) A method for manufacturing a SiC substrate according to a second aspect includes: the method for evaluating a SiC substrate according to the above-described aspect.
(13) A SiC substrate evaluation device according to a third aspect includes: an input unit; and an output unit. The input unit is configured such that an X-ray topographic image of an entire first surface of a SiC substrate is input thereto. The output unit is configured to output a basal plane dislocation density of the SiC substrate.
(14) The SiC substrate evaluation device according to the above-described aspect may further include: a learning unit. The learning unit learns a correlation between respective X-ray topographic images of a plurality of SiC substrates and respective basal plane dislocation densities of the plurality of SiC substrates.
(15) In the SiC substrate evaluation device according to the above-described aspect, the learning unit may be configured to learn through deep learning.
(16) The SiC substrate evaluation device according to the above-described aspect may further include: a memory. The memory is inside the evaluation device or on a server outside the evaluation device. The memory stores measured data of X-ray topographic images of entire first surfaces of a plurality of SiC substrates and basal plane dislocation densities of the plurality of SiC substrates.
(17) In the SiC substrate evaluation device according to the above-described aspect, the learning unit may have a learning program. The learning program learns the correlation between the respective X-ray topographic images of the plurality of SiC substrates and the respective basal plane dislocation densities of the plurality of SiC substrates through deep learning.
(18) In the SiC substrate evaluation device according to the above-described aspect, the learning unit may learn using inverted or rotated images of at least one of the respective X-ray topographic images of the plurality of SiC substrates.
(19) In the SiC substrate evaluation device according to the above-described aspect, the diameter of at least one of the plurality of SiC substrates used for learning by the learning unit may be different from that of the SiC substrate used for obtaining the X-ray topographic image to be input to the input unit.

The method for evaluating a SiC substrate according to the above-described aspect can be used to quickly and non-destructively measure a basal plane dislocation density.

### BRIEF DESCRIPTION OF THE DRAWINGS

FIG. 1 is a plan view of a SiC substrate according to the present embodiment.
FIG. 2 is a flow diagram of a method for evaluating a SiC substrate according to the present embodiment.
FIG. 3 shows measurement results of Example 1.
FIG. 4 shows measurement results of Example 2.
FIG. 5 is a schematic view of a SiC substrate evaluation device according to the present embodiment.

### DETAILED DESCRIPTION

Hereinafter, methods for evaluating and manufacturing a SiC substrate and a SiC substrate evaluation device according to the present embodiment will be described in detail with reference to the drawing as appropriate. In the drawings used in the following description, a part that becomes a feature of the present embodiment is sometimes enlarged for convenience in order to allow the feature to be easily understood, and the dimensional ratios of each constituent element and the like are sometimes different from the actual ones. The materials, dimensions, and the like exemplified in the following description are merely examples, and the present disclosure is not limited thereto and can be implemented by being appropriately modified within the range that does not change the gist thereof.

In the present specification, individual orientations and collective orientations are indicated by [] and <>, respectively. For negative indices, crystallography requires a sign "-" (bar) to be placed above numbers, but in the present specification, numbers are preceded by the negative sign.

In the method for evaluating a SiC substrate according to the present embodiment, a basal plane dislocation density of the SiC substrate is determined.

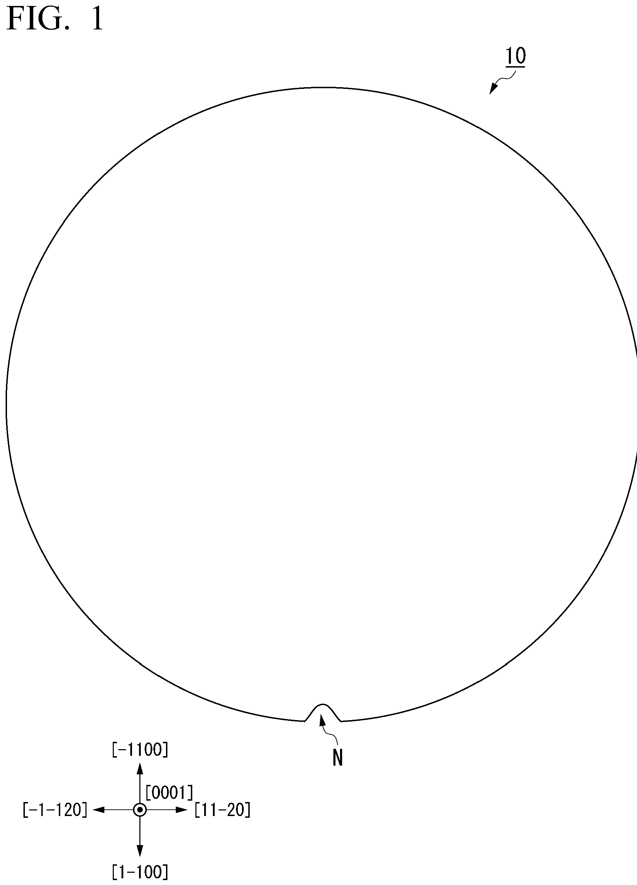

FIG. 1 is a plan view of a SiC substrate 10 according to the present embodiment. FIG. 1 is a view when the SiC substrate is viewed from the <0001> direction. The SiC substrate 10 is made of, for example, n-type SiC. The polytype of SiC substrate 10 is not particularly limited and may be either 2H, 3C, 4H, or 6H. The SiC substrate 10 is, for example, 4H-SiC.

The plan view shape of the SiC substrate 10 is a substantially circular shape. The SiC substrate 10 may have a notch N to ascertain the direction of the crystal axis. In addition, the SiC substrate 10 may also have an orientation flat instead of the notch N.

The diameter of the SiC substrate 10 is, for example, 145 mm or more, preferably 149 mm or more, more preferably 155 mm or less, and still more preferably 151 mm or less. The diameter of the SiC substrate 10 is, for example, 195 mm or more, preferably 199 mm or more, more preferably 205 mm or less, and still more preferably 201 mm or less. The SiC substrate 10 may be, for example, a 6-inch substrate or an 8-inch substrate.

Basal plane dislocations are dislocations that exist on the (0001) plane (=c-plane), which is the basal plane of the SiC substrate 10. The basal plane dislocation density is determined by dividing the number of basal plane dislocations in the SiC substrate 10 by the area of the SiC substrate 10. The SiC substrate 10 may be just a substrate without an offset angle or may be an offset substrate with an offset angle. The offset angle is, for example, 0.1 degrees to 8 degrees.

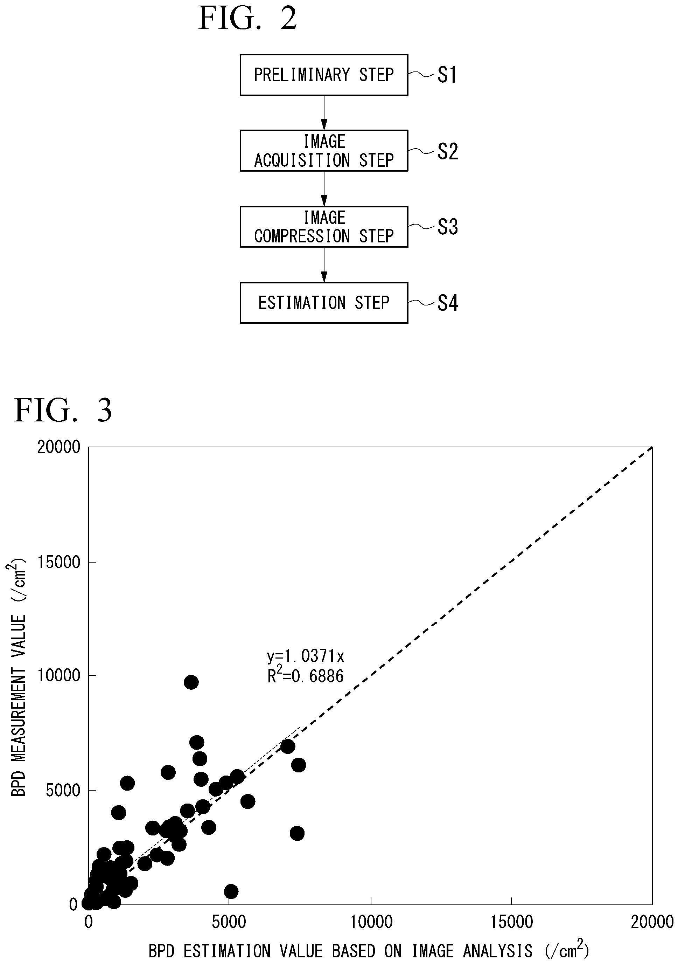

FIG. 2 is a flow diagram of a method for evaluating a SiC substrate according to the present embodiment. The method for evaluating a SiC substrate according to the present embodiment has, for example, Preliminary Step S1, Image Acquisition Step S2, Image Compression Step S3, and Estimation Step S4.

In Preliminary step S 1, respective X-ray topographic images of a plurality of SiC substrates and respective basal plane dislocation densities of the plurality of SiC substrates are measured. These measured data are stored in a memory of an evaluation device. The memory may be stored on a server located outside the evaluation device. A learning program of the evaluation device uses these stored data to learn. The learning program uses deep learning to learn the relationship between the basal plane dislocation densities and the X-ray topographic images of the respective SiC substrates. The data collected in Preliminary Step S1 correspond to teacher data for deep learning. In Preliminary Step S 1, deep learning processing is performed. If actual SiC substrate evaluation is performed with an evaluation device after learning, it is not necessary to perform Preliminary Step S1 at the time of actual evaluation.

In Preliminary Step S1, the relationship between an X-ray topographic image of a SiC substrate and a basal plane dislocation density of the SiC substrate of the X-ray topographic image is acquired as teacher data. The X-ray topographic image of the entire SiC substrate also includes information on overall strain as well as dislocations.

The X-ray topographic image is a topographic image of the entire first surface of the SiC substrate. By using the entire image of the SiC substrate for learning instead of a local image of a defective area, classification of local images is not necessary for estimation processing in Estimation Step S4, and the time required for estimating a basal plane dislocation density can be reduced. In addition, the X-ray topographic image taken may also be compressed to a pixel size of 0.1 mm² or larger, and this compressed image may be used for learning. The pixel size represents a size of one pixel. For example, an image obtained by compressing an X-ray topographic image taken to 250×25d pixels may be used for learning.

The X-ray topographic image of the SiC substrate to be measured in Preliminary Step S1 may be a diffraction image containing a diffraction vector in the <11-20> direction or a diffraction image containing a diffraction vector in the <1-100> direction. The X-ray topographic image of the SiC substrate to be measured in Preliminary Step S1 may be both a diffraction image containing a diffraction vector in the <11-20> direction and a diffraction image containing a diffraction vector in the <1-100> direction.

The number of basal plane dislocations in SiC substrates to be measured in Preliminary Step S1 may be determined from X-ray topographic images, by a photoluminescence method, using a mirror electron microscope, or by measuring etch pits after KOH etching. To obtain highly reliable data as teacher data, it is preferable to evaluate the etch pits after KOH etching and classify the basal plane dislocations in Preliminary Step S 1.

In Preliminary Step S1, the relationship between basal plane dislocation densities and X-ray topographic images of 100 or more SiC substrates is preferably measured as teacher data. The greater the number of teacher data, the higher the accuracy of the estimation of a basal plane dislocation density in Estimation Step S4. If a sufficient number of SiC substrates cannot be prepared, an inverted or rotated image of an X-ray topographic image of a SiC substrate may be used as part of the teacher data for learning. For example, a combination of an X-ray topographic image of a first substrate and a basal plane dislocation density of the first substrate may be used for learning as first data, a combination of an inverted image of the X-ray topographic image of the first substrate and the basal plane dislocation density of the first substrate may be used for learning as second data, and a combination of a rotated image of the X-ray topographic image of the first substrate and the basal plane dislocation density of the first substrate may be used for learning as third data. Here, a use of both an inverted image and a rotated image as part of the teacher data has been exemplified, but only either an inverted image or a rotated image may be used.

The respective diameters of the plurality of SiC substrates to be measured in Preliminary Step S 1 may not necessarily coincide with each other. For example, the plurality of SiC substrates to be measured in Preliminary Step S1 may include both a 6-inch substrate and an 8-inch substrate. In addition, the respective diameters of the plurality of SiC substrates to be measured in Preliminary Step S1 may coincide with each other. For example, the plurality of SiC substrates to be measured in Preliminary Step S1 may be 6-inch substrates or 8-inch substrates.

In addition, the positions of the SiC substrate in a SiC ingot may be added to teacher data. SiC substrates are obtained by cutting from a SiC ingot. In SiC ingots, the tendency of a basal plane dislocation density occurrence may differ between the tail side in the early stage of crystal growth and the head side in the late stage of crystal growth. By adding data on which positions in a SiC ingot the SiC substrate is cut from to teacher data, the accuracy of the estimation of the basal plane dislocation density in Estimation Step S4 can be improved.

The SiC substrate evaluation device learns the correlation between a basal plane dislocation density and an X-ray topographic image of an entire SiC substrate by performing Preliminary Step S 1.

Next, an actual SiC substrate to be evaluated are prepared. The actual SiC substrate to be evaluated preferably have a basal plane dislocation density of 1.0×10⁴/cm² or less. The diameter of the actual SiC substrate to be evaluated may be the same as or different from the diameters of the SiC substrates measured in Preliminary Step S 1. For example, the diameter of the actual SiC substrate to be evaluated may be larger than the diameters of the SiC substrates measured in Preliminary Step S1. If the diameter of the actual SiC substrate to be evaluated is the same as the diameters of the SiC substrates measured in Preliminary Step S 1, the evaluation accuracy increases.

In Image Acquisition Step S2, the X-ray topographic image of the entire first surface of the actual SiC substrate to be evaluated is acquired. The first surface of the SiC substrate for which the X-ray topographic image is acquired may be chemically mechanically polished (CMP) surface or ground surface before performing CMP polishing.

The X-ray topographic image of the SiC substrate to be acquired in Image Acquisition Step S2 may be diffraction image containing a diffraction vector in the <11-20> direction or diffraction image containing a diffraction vector in the <1-100> direction. The X-ray topographic images of the SiC substrate to be acquired in Image Acquisition Step S2 may be both diffraction image containing a diffraction vector in the <11-20> direction and diffraction image containing a diffraction vector in the <1-100> direction. The X-ray topographic image of the SiC substrate to be acquired in Image Acquisition Step S2 is diffraction image containing a diffraction vector in the same direction as the X-ray topographic image of the SiC substrates measured in Preliminary Step S1.

Subsequently, the X-ray topographic image acquired in the image acquisition step is compressed in Image Compression Step S3. In Image Compression Step S3, the pixel size of the X-ray topographic image is 0.1 mm² or larger. If the diameters of the SiC substrates measured in Preliminary Step S1 are different from the diameter of the actual SiC substrate to be evaluated, the X-ray topographic images obtained using the respective SiC substrates for measurement are compressed to the same size (for example, 250×250 pixels).

The resolution of each X-ray topographic image is reduced by performing Image Compression Step S3. By performing Image Compression Step S3, arithmetic operations in Estimation Step S4 can be performed based on low-resolution image, reducing computational loads on the evaluation device. If the computing power of the evaluation device is sufficiently high, Image Compression Step S3 may not need to be performed.

Subsequently, Estimation Step S4 is performed. In Estimation Step S4, the basal plane dislocation density of the SiC substrate to be evaluated is estimated from the X-ray topographic image of the entire first surfaces of the SiC substrate to be evaluated based on the learning results of deep learning.

The X-ray topographic image used for image analysis in Estimation Step S4 is the X-ray topographic image acquired in Image Acquisition Step S2. When Image Compression Step S3 is performed, the X-ray topographic image compressed in Image Compression Step S3 is used for image analysis in Estimation Step S4.

The evaluation device learned by deep learning in Preliminary Step S 1 outputs the basal plane dislocation density of the SiC substrate using the X-ray topographic image of the entire first surface of the SiC substrate as input. Since the correlation between the X-ray topographic images and the basal plane dislocation densities are learned by deep learning, the evaluation device can estimate the basal plane dislocation density of the SiC substrate to be evaluated with high accuracy.

As described above, the method for evaluating a SiC substrate according to the present embodiment uses topographic image of the entire first surface of the SiC substrate to estimate the basal plane dislocation density of the SiC substrate. Classifying individual defects to determine the basal plane dislocation density requires classification of individual defects, and it takes time to measure the basal plane dislocation density. In contrast, the method for evaluating a SiC substrate according to the present embodiment can reduce the time required to evaluate the basal plane dislocation density because the basal plane dislocation density of the SiC substrate can be determined from the entire image, rather than by classifying individual defects.

In addition, the topographic image of the entire first surface of the SiC substrate include information on defects and strain in the SiC substrate. The method for evaluating a SiC substrate according to the present embodiment is highly accurate in estimating the basal plane dislocation density because it learns based on topographic image including both microscopic information on defects in SiC substrate and macroscopic information on strain in SiC substrates.

In addition, the method for evaluating a SiC substrate according to the present embodiment can reduce computational loads of the evaluation device that estimates the basal plane dislocation density by performing Image Compression Step S3. When trying to accurately estimate the basal plane dislocation density, it is common to try to increase the resolution of the image, but it has been found that the basal plane dislocation density can be estimated with high accuracy even if the resolution of the image is reduced in the present embodiment.

In addition, by defining the pixel size of the images in Image Compression Step S3, the basal plane dislocation density of the SiC substrate to be evaluated can be estimated even if the diameters of the SiC substrates used for measurement in Preliminary Step S 1 are different from diameter of the SiC substrate to be evaluated. For example, it is difficult to manufacture 8-inch substrates, and it is difficult to prepare many samples in Preliminary Step S 1_ Even in this case, Preliminary Step S 1 can be performed on 6-inch substrates, and the basal plane dislocation density of 8-inch substrate can be estimated based on the learning results on the 6-inch substrates.

In addition, the method for evaluating a SiC substrate according to the present embodiment can be included in one process of a method for manufacturing a SiC substrate and a SiC epitaxial wafer. Since method for evaluating a SiC substrate according to the present embodiment can evaluate basal plane dislocation density of the

SiC substrate simply and quickly, defective SiC substrates and SiC epitaxial wafers with a high basal plane dislocation density can be excluded during the manufacturing process, thereby increasing the percentage of good SiC substrates and SiC epitaxial wafers. This method for evaluating a SiC substrate according to the present embodiment is also applicable when the basal plane dislocation density is as low as 1.0×10⁴/cm² or less.

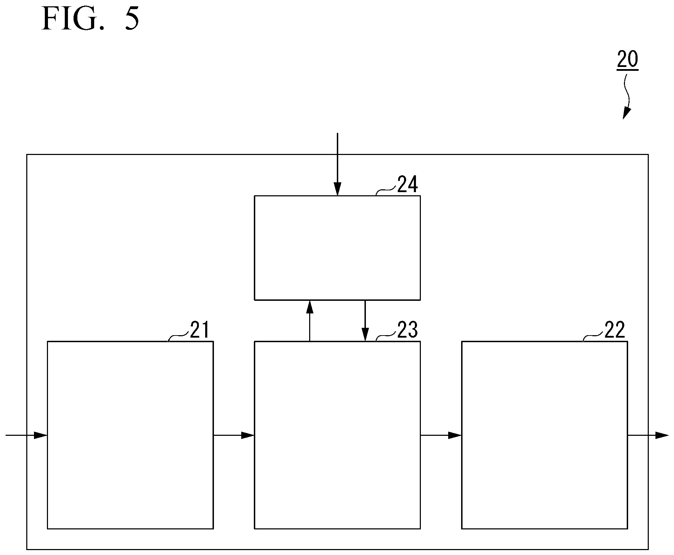

FIG. 5 is a schematic view of a SiC substrate evaluation device 20 according to the present embodiment. The SiC substrate evaluation device 20 has, for example, an input unit 21, an output unit 22, a learning unit 23, and a memory 24. The evaluation device 20 performs learning and inference.

Learning of the evaluation device 20 is performed by the learning unit 23 and the memory 24. The memory 24 stores measured data of respective X-ray topographic images of a plurality of SiC substrates and respective basal plane dislocation densities of the plurality of SiC substrates. The data stored in the memory 24 are the data measured in Preliminary Step S 1. The data are stored in the memory 24 during Preliminary Step S 1. FIG. 5 illustrates an example in which the memory 24 is incorporated in the evaluation device 20, but the memory 24 may be in a server outside the evaluation device 20.

The learning unit 23 learns the correlation between the respective X-ray topographic images of the plurality of SiC substrates and the respective basal plane dislocation densities of the plurality of SiC substrates based on the data stored in the memory 24. A learning program is stored in the learning unit 23. By running the learning program, the learning unit 23 performs learning. Learning is performed, for example, by deep learning. Each piece of data used for learning is a relationship between the X-ray topographic images of the SiC substrates and the basal plane dislocation densities of the SiC substrates. The greater the number of data used for learning, the higher the accuracy of the learning. If a sufficient number of SiC substrates cannot be prepared, inverted or rotated images of at least one of the respective X-ray topographic images of the plurality of SiC substrates may be used for learning.

Inference in the evaluation device 20 is performed by the input unit 21, the learning unit 23, and the output unit 22. The input unit 21 is configured such that X-ray topographic image of an entire first surface of the SiC substrate is input thereto. Here, the X-ray topographic image of the SiC substrate to be evaluated for which basal plane dislocation density is not known are input to the input unit 21.

The learning unit 23 estimates basal plane dislocation density of the SiC substrate to be evaluated from the input X-ray topographic image based on the results learned during learning. The learning unit 23 does not learn during inference, but performs estimation based on the learning results.

The output unit 22 is configured to output the basal plane dislocation density of the SiC substrate to be evaluated. The evaluation device 20 estimates the basal plane dislocation density of the SiC substrate to be evaluated from the X-ray topographic image based on the learning results.

The X-ray topographic image input to the input unit 21 and the basal plane dislocation density output from the output unit 22 may be stored in the memory 24 as one of the teacher data. Including the inference results in the teacher data can increase the number of teacher data and enhance the learning system of the evaluation device 20.

Although the preferred embodiment of the present disclosure has been described in detail above, the present disclosure is not limited to a specific embodiment and various modifications and changes can be made within the scope of the gist of the present disclosure disclosed in the claims.

### [Examples]

First, 800 X-ray topographic images of SiC substrates with a diameter of 150 mm were prepared. In addition, some of these images were also inverted and rotated to prepare 4,000 X-ray topographic images. Each of the 4,000 X-ray topographic images was compressed to 250×250 pixels.

Subsequently, the evaluation device was learned by deep learning to correlate the 4,000 X-ray topographic images with the number of basal plane dislocations of the SiC substrates of the respective X-ray topographic images. The programming language of the program used for learning was Python-based. The program was created with tkinter for a GUI application and TensorFlow-Keras for a deep learning module. In addition, information on which positions in a SiC ingot SiC substrates are cut from was also added to the teacher data.

In Example 1, basal plane dislocation densities of SiC substrates on the tail side of a SiC ingot (early stage of crystal growth) were determined. Both actual measurement values and estimation values using the method for evaluating a SiC substrate according to the present embodiment were determined for the basal plane dislocation densities. The actual measurement values are values obtained by classifying etch pits after KOH etching and determining the number of basal plane dislocations. Estimation values were obtained using images obtained by compressing acquired X-ray topographic images of SiC substrates to be measured to 250×250 pixels. FIG. 3 shows evaluation results of Example 1. A correlation coefficient R² of Example 1 was 0.6886, confirming a high correlation between the actual measurement values and the estimation values.

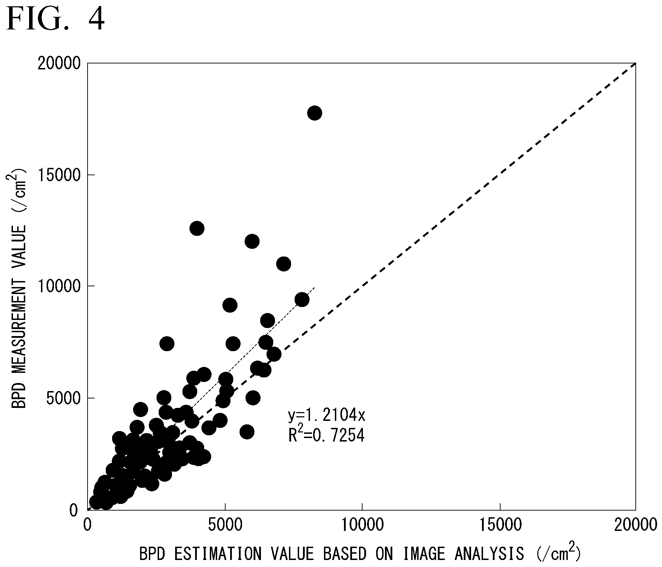

In Example 2, basal plane dislocation densities of SiC substrates on the head side of the SiC ingot (late stage of crystal growth) were determined. Both actual measurement values and estimation values using the method for evaluating a SiC substrate according to the present embodiment were determined for the basal plane dislocation densities. The actual measurement values are values obtained by classifying etch pits after KOH etching and determining the number of basal plane dislocations. Estimation values were obtained using images obtained by compressing acquired X-ray topographic images of SiC substrates to be measured to 250×250 pixels. FIG. 4 shows evaluation results of Example 2. A correlation coefficient R² of Example 2 was 0.7254, confirming a high correlation between the actual measurement values and the estimation values.

As shown in Example 1 and Example 2, the method for evaluating a SiC substrate according to the present embodiment can be used to easily estimate basal plane dislocation densities of SiC substrates. In addition, even when compressed images were used, basal plane dislocation densities could be determined with sufficient accuracy.

### EXPLANATION OF REFERENCES

10 SiC Substrate
N Notch
S1 Preliminary step
S2 Image acquisition step
S3 Image compression step
S4 Estimation step

## Claims

1. A method for evaluating a SiC substrate, comprising:
an image acquisition step of acquiring an X-ray topographic image of an entire first surface of a SiC substrate; and
an estimation step of estimating a basal plane dislocation density of the SiC substrate from the X-ray topographic image of the entire first surface of the SiC substrate based on learning results of deep learning.

2. The method for evaluating a SiC substrate according to claim 1, the method further comprising:
an image compression step of compressing the X-ray topographic image acquired in the image acquisition step,
wherein, in the image compression step, the pixel size of the X-ray topographic image is 0.1 mm² or larger, and
wherein the estimation step is performed using a compressed X-ray topographic image.

3. The method for evaluating a SiC substrate according to claim 1 or 2, the method further comprising:
a preliminary step of measuring respective X-ray topographic images of a plurality of SiC substrates and respective basal plane dislocation densities of the plurality of SiC substrates,
wherein, in the preliminary step, a relationship between the basal plane dislocation densities and the X-ray topographic images of the respective SiC substrates is learned by the deep learning.

4. The method for evaluating a SiC substrate according to claim 3,
wherein the number of SiC substrates measured in the preliminary step is 100 or more.

5. The method for evaluating a SiC substrate according to claim 3 or 4,
wherein inverted or rotated images of the X-ray topographic images acquired in the preliminary step are used for the learning.

6. The method for evaluating a SiC substrate according to any one of claims 1 to 5,
wherein the X-ray topographic image is a diffraction image containing a diffraction vector in the <11-20> direction.

7. The method for evaluating a SiC substrate according to any one of claims 1 to 6,
wherein the X-ray topographic image is a diffraction image containing a diffraction vector in the <1-100> direction.

8. The method for evaluating a SiC substrate according to any one of claims 1 to 7,
wherein the SiC substrate has a diameter of 145 mm or more.

9. The method for evaluating a SiC substrate according to any one of claims 1 to 8,
wherein the SiC substrate has a diameter of 195 mm or more.

10. The method for evaluating a SiC substrate according to any one of claims 3 to 5,
wherein the diameters of the SiC substrates to be measured in the preliminary step are different from that of the SiC substrate for which the X-ray topographic image is acquired in the image acquisition step.

11. The method for evaluating a SiC substrate according to any one of claims 1 to 10,
wherein the basal plane dislocation density of the SiC substrate is 1.0×10⁴/cm² or less.

12. A method for manufacturing a SiC substrate, comprising:
the method for evaluating a SiC substrate according to any one of claims 1 to 11.

13. A SiC substrate evaluation device comprising:
an input unit; and
an output unit,
wherein the input unit is configured such that an X-ray topographic image of an entire first surface of a SiC substrate is input thereto, and
wherein the output unit is configured to output a basal plane dislocation density of the SiC substrate.

14. The SiC substrate evaluation device according to claim 13, the device further comprising:
a learning unit,
wherein the learning unit learns a correlation between respective X-ray topographic images of a plurality of SiC substrates and respective basal plane dislocation densities of the plurality of SiC substrates.

15. The SiC substrate evaluation device according to claim 14,
wherein the learning unit is configured to learn through deep learning.

16. The SiC substrate evaluation device according to any one of claims 13 to 15, the device further comprising:
a memory,
wherein the memory is inside the evaluation device or on a server outside the evaluation device, and
wherein the memory stores measured data of X-ray topographic images of entire first surfaces of a plurality of SiC substrates and basal plane dislocation densities of the plurality of SiC substrates.

17. The SiC substrate evaluation device according to claim 14 or 15,
wherein the learning unit has a learning program, and
wherein the learning program learns the correlation between the respective X-ray topographic images of the plurality of SiC substrates and the respective basal plane dislocation densities of the plurality of SiC substrates through deep learning.

18. The SiC substrate evaluation device according to any one of claims 14, 15 and 17,
wherein the learning unit learns using inverted or rotated images of at least one of the respective X-ray topographic images of the plurality of SiC substrates.

19. The SiC substrate evaluation device according to any one of claims 14, 15, 17 and 18,
wherein the diameter of at least one of the plurality of SiC substrates used for learning by the learning unit is different from that of the SiC substrate used for obtaining the X-ray topographic image to be input to the input unit.
